(19) **Europäisches Patentamt** / **European Patent Office** / **Office européen des brevets**

(11) **EP 4 279 990 A1**

(12) **EUROPEAN PATENT APPLICATION**
published in accordance with Art. 153(4) EPC

(43) Date of publication:
**22.11.2023 Bulletin 2023/47**

(21) Application number: **21919548.4**

(22) Date of filing: **12.11.2021**

(51) International Patent Classification (IPC):
**G03F 1/24** (2012.01)          **C23C 14/06** (2006.01)

(52) Cooperative Patent Classification (CPC):
**C23C 14/06; G03F 1/24**

(86) International application number:
**PCT/JP2021/041787**

(87) International publication number:
**WO 2022/153657 (21.07.2022 Gazette 2022/29)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **12.01.2021   JP 2021003105**

(71) Applicant: **Toppan Photomask Co., Ltd.
Tokyo 108-0023 (JP)**

(72) Inventors:
• **NAKANO, Hideaki**
  **Tokyo 110-0016 (JP)**
• **GODA, Ayumi**
  **Tokyo 110-0016 (JP)**
• **ICHIKAWA, Kenjiro**
  **Tokyo 110-0016 (JP)**
• **YAMAGATA, Yuto**
  **Tokyo 110-0016 (JP)**

(74) Representative: **Hoffmann Eitle
Patent- und Rechtsanwälte PartmbB
Arabellastraße 30
81925 München (DE)**

(54) **REFLECTIVE PHOTOMASK BLANK AND REFLECTIVE PHOTOMASK**

(57)    There is provided a reflective photomask blank capable of suppressing or reducing the shadowing effect of a reflective photomask for patterning transfer using a light having a wavelength in the extreme ultraviolet region as a light source and sufficiently having heat resistance in exposure. The reflective photomask blank is configured to have a substrate 1, a reflective layer 2 including a multi-layer film formed on the substrate 1, and an absorption layer 4 formed on the reflective layer 2. The absorption layer 4 contains a total of 50 at% or more of indium (In) and nitrogen (N). The atomic number ratio (N/In) of nitrogen (N) to indium (In) in the absorption layer 4 is set to 0.5 or more and 1.5 or less. The layer thickness of the absorption layer 4 is set to 17 nm or more and 45 nm or less.

FIG. 2

EP 4 279 990 A1

**Description**

Technical Field

The present invention relates to a reflective photomask used in lithography using a light in the ultraviolet region as a light source and a reflective photomask blank for producing the same.

Background Art

In a manufacturing process of semiconductor devices, a demand for miniaturization by a photolithography technology has increased with the miniaturization of the semiconductor devices. The minimum resolution dimension of a transfer pattern in the photolithography largely depends on the wavelength of an exposure light source, and the minimum resolution dimension can be made smaller as the wavelength is shorter. Therefore, as the exposure light source, a conventional ArF excimer laser light having a wavelength of 193 nm has been replaced with a light in the EUV (Extreme Ultra Violet) region having a wavelength of 13.5 nm.

The light in the EUV region is absorbed by most materials at a high ratio, and therefore a reflective photomask is used as a photomask for EUV exposure (EUV mask) (see PTL 1, for example). PTL 1 discloses an EUV photomask obtained by forming a reflective layer containing a multi-layer reflective film in which molybdenum (Mo) layers and silicon (Si) layers are alternately deposited on a glass substrate, forming a light absorption layer containing tantalum (Ta) as the main ingredient on the reflective layer, and forming a pattern on the light absorption layer.

Further, in the EUV lithography, a dioptric system utilizing light transmission cannot be used as described above, and therefore an optical system member of an exposure machine is not a lens but a reflective type (mirror). This poses a problem that an incident light and a reflected light on a reflective photomask (EUV mask) cannot be coaxially designed. Thus, in the EUV lithography, a technique is commonly employed which includes making the EUV light incident by tilting the optical axis by 6° from the vertical direction of the EUV mask and guiding a reflected light reflected at an angle of -6° to a semiconductor substrate.

As described above, the optical axis is tilted through the mirror in the EUV lithography, and therefore there is a possibility of the occurrence of a so-called "shadowing effect" in which the EUV light incident on the EUV mask creates a shadow of a mask pattern (patterned absorption layer) of the EUV mask.

In a current EUV mask blank, a film containing tantalum (Ta) as the main ingredient and having a layer thickness of 60 to 90 nm is used as the light absorption layer. When the exposure of pattern transfer is performed with an EUV mask produced using the mask blank, there is a possibility of causing a reduction in the contrast in an edge part to be shadowed by the mask pattern, depending on the relationship between the incident direction of the EUV light and the orientation of the mask pattern. Consequently, problems, such as an increase in line edge roughness of the transfer pattern on the semiconductor substrate and an inability to form a line width with a target dimension, occur, thereby deteriorating the transfer performance in some cases.

Thus, for the light absorption layer, a change of a material from tantalum (Ta) to a material having high absorptivity (extinction coefficient) to the EUV light has been studied. However, depending on the material used for the light absorption layer of the reflective mask blank, there is a possibility that the material cannot withstand heat in EUV exposure, and a formed transfer pattern (mask pattern) cannot be stably maintained, resulting in deterioration of transferability.

Citation List

Patent Literature

PTL 1: JP 2011-176162 A

Summary of Invention

Technical Problem

Thus, it is an object of the present invention to provide a reflective photomask blank and a reflective photomask capable of suppressing or reducing the shadowing effect of a reflective photomask for patterning transfer using a light having a wavelength in the extreme ultraviolet region as a light source and sufficiently having heat resistance in exposure.

Solution to Problem

To solve the above-described problems, a reflective photomask blank according to one aspect of the present invention is a reflective photomask blank for producing a reflective photomask for pattern transfer using an extreme ultraviolet light as a light source, and includes: a substrate; a reflective layer including a multi-layer film formed on the substrate; and an absorption layer formed on the reflective layer, in which the absorption layer contains a total of 50 at% or more of indium (In) and nitrogen (N), the atomic number ratio (N/In) of nitrogen (N) to indium (In) in the absorption layer is 0.5 or more and 1.5 or less, and the layer thickness of the absorption layer is 17 nm or more and 45 nm or less.

The absorption layer may further contain one or more elements selected from the group consisting of tantalum (Ta), platinum (Pt), tellurium (Te), zirconium (Zr), hafnium (Hf), titanium (Ti), tungsten (W), silicon (Si), chromium (Cr), gallium (Ga), molybdenum (Mo), tin (Sn), palladium (Pd), nickel (Ni), boron (B), fluorine (F), oxygen (O), carbon (C), and hydrogen (H).

A capping layer is included between the reflective layer and the absorption layer.

A reflective photomask according to one aspect of the present invention is a reflective photomask for pattern transfer using an extreme ultraviolet light as a light source, and includes: a substrate; a reflective layer including a multi-layer film formed on the substrate; and an absorption pattern layer formed on the reflective layer, in which the absorption pattern layer contains a total of 50 at% or more of indium (In) and nitrogen (N), the atomic number ratio (N/In) of nitrogen (N) to indium (In) in the absorption layer is 0.5 or more and 1.5 or less, and the layer thickness of the absorption pattern layer is 17 nm or more and 45 nm or less.

The absorption pattern layer may further contain one or more elements selected from the group consisting of tantalum (Ta), platinum (Pt), tellurium (Te), zirconium (Zr), hafnium (Hf), titanium (Ti), tungsten (W), silicon (Si), chromium (Cr), gallium (Ga), molybdenum (Mo), tin (Sn), palladium (Pd), nickel (Ni), boron (B), fluorine (F), oxygen (O), carbon (C), and hydrogen (H).

Advantageous Effects of Invention

According to one aspect of the present invention, a reflective photomask can be expected in which the transfer performance to a semiconductor substrate is improved in patterning using a light having a wavelength in the extreme ultraviolet region as a light source and which has heat resistance in exposure. More specifically, the reflective photomask blank and the reflective photomask according to one aspect of the present invention suppresses or reduces the shadowing effect of the reflective photomask for patterning transfer using a light having a wavelength in the extreme ultraviolet region as a light source and sufficiently having resistance also to EUV light irradiation.

Brief Description of Drawings

FIG. 1 is a schematic cross-sectional view illustrating the structure of a reflective photomask blank according to an embodiment;

FIG. 2 is a schematic cross-sectional view illustrating the structure of a reflective photomask according to an embodiment;

FIG. 3 is a graph showing the optical constant of each element at the wavelength of an EUV light;

FIG. 4 is a schematic cross-sectional view illustrating the structure of a reflective photomask blank according to Examples;

FIG. 5 is a schematic cross-sectional view illustrating a manufacturing process of a reflective photomask according to Examples;

FIG. 6 is a schematic cross-sectional view illustrating a manufacturing process of the reflective photomask according to Examples;

FIG. 7 is a schematic cross-sectional view illustrating a manufacturing process of the reflective photomask according to Examples;

FIG. 8 is a schematic cross-sectional view illustrating a manufacturing process of the reflective photomask according to Examples; and

FIG. 9 is a schematic plan view illustrating the shape of a mask pattern of an absorption layer.

Description of Embodiments

Hereinafter, embodiments of the present invention are described with reference to the drawings, but the present invention is not limited to the following embodiments. In the embodiments described below, a technically preferable limitation is made to implement the present invention, but this limitation is not a requirement of the present invention.

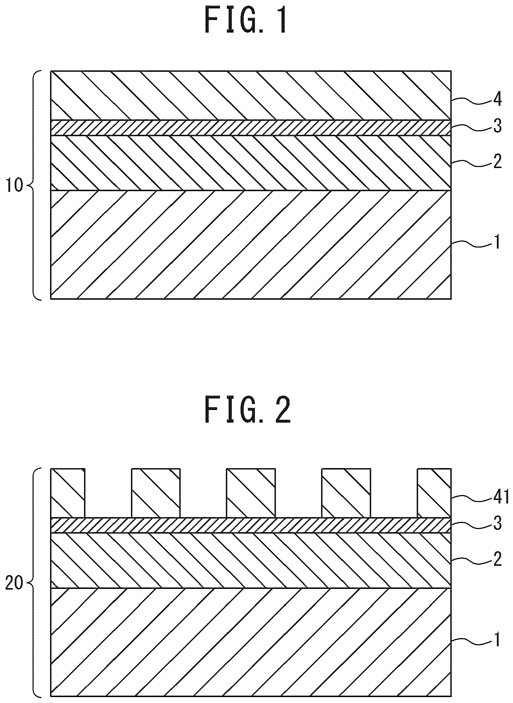

FIG. 1 is a schematic cross-sectional view illustrating the structure of a reflective photomask blank 10 according to an embodiment of the present invention. FIG. 2 is a schematic cross-sectional view illustrating the structure of a reflective photomask 20 according to an embodiment of the present invention. Herein, the reflective photomask 20 according to the embodiment of the present invention illustrated in FIG. 2 is formed by patterning an absorption layer 4 of the reflective photomask blank 10 according to the embodiment of the present invention illustrated in FIG. 1.

(Entire configuration)

As illustrated in FIG. 1, the reflective photomask blank 10 according to the embodiment of the present invention includes a substrate 1, a reflective layer 2 formed on the substrate 1, a capping layer 3 formed on the reflective layer 2, and the absorption layer 4 formed on the capping layer 3.

(Substrate)

For the substrate 1 according to the embodiment of the present invention, a flat Si substrate, a synthetic quartz substrate, or the like is usable, for example. Further, a low thermal expansion glass to which titanium is added is usable for the substrate 1. However, this embodiment is not limited to the above, and any material having a small thermal expansion coefficient may be acceptable.

(Reflective layer)

The reflective layer 2 according to the embodiment of the present invention may be one reflecting an EUV light (extreme ultraviolet light), which is an exposure light, or may be a multi-layer reflective film containing a combination of materials having greatly different refractive indices to the EUV light. As the reflective layer 2 including the multi-layer reflective film, one formed by repeatedly depositing a layer containing a combination of molybdenum (Mo) and silicon (Si) or molybdenum (Mo) and beryllium (Be) by about 40 cycles may be acceptable, for example.

(Capping layer)

The capping layer 3 according to the embodiment of the present invention is formed of a material having resistance to dry etching performed in forming a transfer pattern (mask pattern) on the absorption layer 4 and functions as an etching stopper to prevent damage to the reflective layer 2 when the absorption layer 4 is etched. The capping layer 3 is formed of Ru (ruthenium), for example. Herein, the capping layer 3 may not be formed depending on materials of the reflective layer 2 and the etching conditions. Although not illustrated in the drawings, a back surface conductive film can be formed on the surface on which the reflective layer 2 is not formed of the substrate 1. The back surface conductive film is a film for fixing the reflective photomask 20 utilizing the principle of an electrostatic chuck when the reflective photomask 20 is installed in an exposure machine.

(Absorption layer)

An absorption pattern (absorption pattern layer) 41 of the reflective photomask 20 is formed by removing a part of the absorption layer 4 of the reflective photomask blank 10, i.e., patterning the absorption layer 4. In the EUV lithography, the EUV light is obliquely incident and reflected by the reflective layer 2. The transfer performance onto a wafer (semiconductor substrate) sometimes deteriorates due to a shadowing effect in which the absorption pattern layer 41 interferes with an optical path. This deterioration of the transfer performance is improved by reducing the thickness of the absorption layer 4 absorbing the EUV light. To reduce the thickness of the absorption layer 4, a material having higher absorptivity to the EUV light than that of a conventional material, i.e., a material having a high extinction coefficient k to a wavelength of 13.5 nm, is preferably applied.

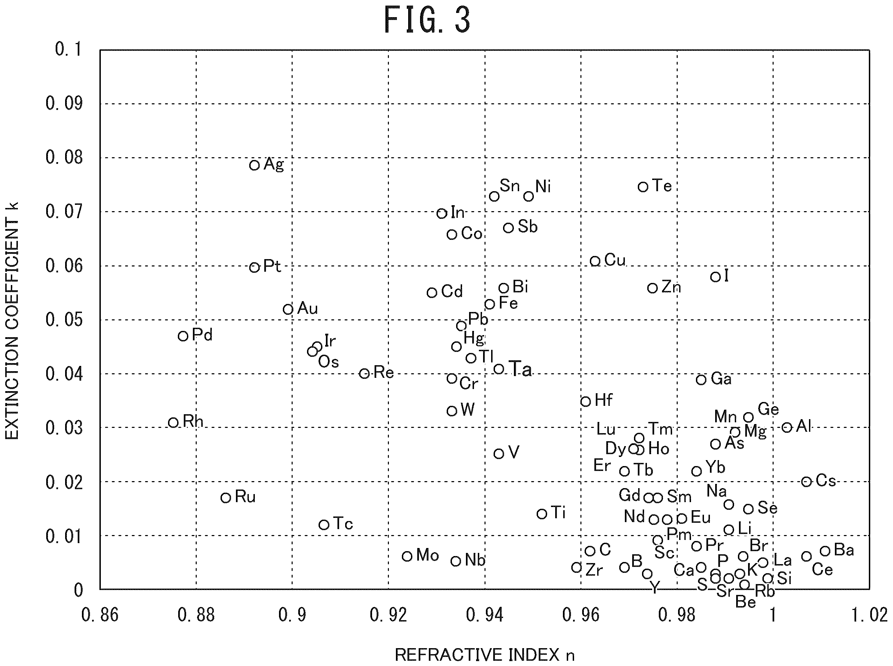

FIG. 3 is a graph showing the optical constant to the wavelength of 13.5 nm of the EUV light of each metal material. The horizontal axis of FIG. 3 represents the refractive index n and the vertical axis represents the extinction coefficient k. The extinction coefficient k of tantalum (Ta), which is a main material of the conventional absorption layer 4, is 0.041. Compound materials having a larger extinction coefficient k can further reduce the thickness of the absorption layer 4 as compared with conventional compound materials. When the extinction coefficient k is 0.06 or more, the thickness of the absorption layer 4 can be sufficiently reduced, and the shadowing effect can be reduced.

As materials satisfying the optical constants (nk value) described above, silver (Ag), platinum (Pt), indium (In), cobalt (Co), tin (Sn), nickel (Ni), and tellurium (Te) are mentioned, for example, as illustrated in FIG. 3. However, these metal materials have problems of low volatility when halogenated and poor dry etching properties. Therefore, even when a reflective photomask blank including an absorption layer formed of these metal materials is produced, the absorption layer pattern cannot be patterned to the absorption layer, resulting in a problem that the reflective photomask blank cannot be processed into the reflective photomask. Alternatively, the melting points of these metal materials are low, and therefore these metal materials cannot withstand heat in the production or EUV exposure of the reflective photomask, which poses a problem that the reflective photomask has poor practicality.

To avoid the above-described drawbacks, the absorption layer of each of the reflective photomask blank and the reflective photomask of the present invention has InN, which is a nitride of indium. In the case of In alone, the melting point is around 157°C, which is lower than the temperature of heat in the production or EUV exposure of the reflective photomask, and thus the thermal stability is problematic. On the other hand, the melting point of an oxide InO film is 800°C or more, which is sufficiently high, but can be set to 1100°C or more by forming a nitride. Thus, an InN film has sufficient resistance to heat in the production or EUV exposure of the reflective photomask.

While the InN film is chemically stable, dry etching using a chlorine-based gas is possible, and therefore the reflective photomask blank can be processed into the reflective photomask. This is because the volatility of InCl$_3$, which is a compound of In and chlorine (Cl), is higher than that of high absorption materials other than In illustrated in FIG. 3.

Materials containing indium (In) and nitrogen (N) for forming the absorption layer 4 have an atomic number ratio (N/In) of nitrogen (N) to indium (In) of preferably 0.5 or more and 1.5 or less. Due to the fact that the atomic number ratio of indium (In) and nitrogen (N) in the material constituting the absorption layer 4 is 0.5 or more, sufficient heat resistance can be imparted.

It was able to be confirmed that a film having an atomic number ratio of nitrogen (N) to indium (In) of more than 1.5 cannot be formed, and thus the atomic number ratio was set as the upper limit. The atomic number ratio (N/In) of 1.0 is stoichiometrically stable, and therefore is preferably within the range of 0.7 or more and 1.2 or less and more preferably within the range of 0.8 or more and 1.0 or less.

A material constituting the absorption layer 4 preferably contains a total of 50 at% or more of indium (In) and nitrogen (N). This is because, when the absorption layer 4 contains ingredients other than indium (In) and nitrogen (N), there is a possibility that both the EUV light absorptivity and the heat resistance decrease, but, when the proportion of the ingredients other than indium (In) and nitrogen (N) is less than 50 at%, the decrease in the EUV light absorptivity and the heat resistance is negligible, and there is almost no decrease in the performance as the absorption layer 4 of the EUV mask.

As materials other than indium (In) and nitrogen (N), Ta, Pt, Te, Zr, Hf, Ti, W, Si, Cr, Ga, Mo, Sn, Pd, Ni, B, F, O, C, or H may be mixed, for example. More specifically, the absorption layer 4 may further contain, besides indium (In) and nitrogen (N), one or more elements selected from the group consisting of Ta, Pt, Te, Zr, Hf, Ti, W, Si, Cr, Ga, Mo, Sn, Pd, Ni, B, F, O, C, and H.

For example, by mixing Ta, Pt, Te, Sn, Pd, Ni into the absorption layer 4, conductivity can be imparted to the film (absorption layer 4) while high absorptivity to the EUV light is being secured. Therefore, in a mask pattern inspection using a deep ultra violet (DUV) light having a wavelength of 190 to 260 nm, the inspection property can be enhanced. Alternatively, when Ga, Hf, Zr, Mo, Cr, F are mixed into the absorption layer 4, the film quality can be made more amorphous. This can improve the roughness and the in-plane dimension uniformity of the absorption layer pattern (mask pattern) after dry etching or the in-plane uniformity of a transferred image. When Ti, W, Si are mixed into the absorption layer 4, the resistance to cleaning can be enhanced.

The content of one or more elements selected from the group consisting of Ta, Pt, Te, Zr, Hf, Ti, W, Si, Cr, Ga, Mo, Sn, Pd, Ni, B, F, O, C, and H in the absorption layer 4 and the absorption pattern layer 41 is more preferably within the range of 5 at% or more and 35 at% or less and more preferably within the range of 10 at% or more and 30 at% or less based on the total number of atoms constituting the absorption layer 4 or the total number of atoms constituting the absorption pattern layer 41.

Although FIGS. 1 and 2 illustrate a single-layer absorption layer 4, the absorption layer 4 according to the embodiment of the present invention is not limited thereto. The absorption layer 4 according to the embodiment of the present invention may be an absorption layer containing one or more layers, i.e., multiple-layer absorption layer, for example.

For the conventional absorption layer 4 of the EUV reflective photomask, a compound material containing Ta as the main ingredient has been applied as described above. In this case, to obtain 1 or more in the optical density OD (Equation 1), which is an index showing the light intensity contrast between the absorption layer 4 and the reflective layer 2, the film thickness of the absorption layer 4 needed to be 40 nm or more, and, to obtain 2 or more in the OD, the film thickness of the absorption layer 4 needed to be 70 nm or more. Although the extinction coefficient k of Ta is 0.041, the application of a compound material containing indium (In) and nitrogen (N) and having an extinction coefficient k of 0.06 or more to the absorption layer 4 enables a decrease in the film thickness of the absorption layer 4 up to 17 nm when the OD is at least 1 or more and a decrease in the film thickness of the absorption layer 4 to 45 nm or less when the OD is 2 or more by the Beer's law. However, when the film thickness of the absorption layer 4 exceeds 45 nm, the shadowing effect is almost the same as that of the conventional absorption layer 4 having a film thickness of 60 nm formed of the conventional compound material containing Ta as the main ingredient.

$$OD = -\log(Ra/Rm)\cdots(\text{Equation 1})$$

Therefore, the film thickness of the absorption layer 4 according to the embodiment of the present invention is 17 nm or more and 45 nm or less. More specifically, when the film thickness of the absorption layer 4 is within the range of 17 nm or more and 45 nm or less, the shadowing effect can be sufficiently reduced and the transfer performance is further improved as compared with the conventional absorption layer 4 formed of the compound material containing Ta as the main ingredient. The optical density (OD) value is the contrast between the absorption layer 4 and the reflective layer 2. When the OD value is less than 1, a sufficient contrast cannot be obtained and the transfer performance tends to decrease.

The above-described "main ingredient" refers to an ingredient contained in the proportion of 50 at% or more based on the number of atoms of the entire absorption layer.

Hereinafter, Examples of the reflective photomask blank and the reflective photomask according to the present invention are described.

[Example 1]

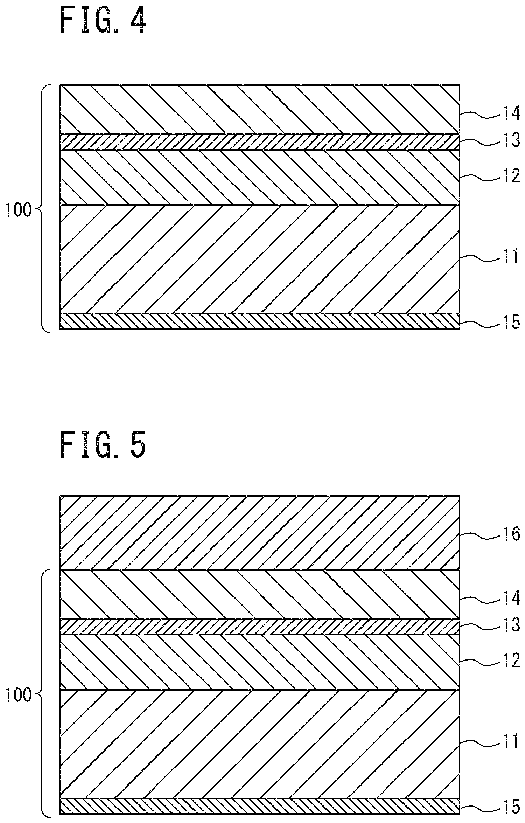

First, a method for producing a reflective photomask blank 10 is described with reference to FIG. 4.

In Example 1, a synthetic quartz substrate 11 having a low thermal expansion property was first prepared as illustrated in FIG. 4. Next, a reflective layer 12 formed by depositing 40 multi-layer films each containing a pair of silicon (Si) and molybdenum (Mo) was formed on the prepared substrate 11. The film thickness of the reflective layer 12 was set to 280 nm. Next, a capping layer 13 was formed as an intermediate film on the reflective layer 12. As a material of the capping layer 13, ruthenium (Ru) was used. The film thickness of the capping layer 13 was set to 3.5 nm.

Next, an absorption layer 14 containing a total of 100 at% of indium (In) and nitrogen (N) was formed on the capping layer 13. Herein, the atomic number ratio (N/In) of indium (In) and nitrogen (N) of the absorption layer 14 was 1.0 (= 1:1) as measured by XPS (X-ray photoelectron spectroscopy). Further, as a result of the measurement by XRD (X-ray diffractometer), the crystallinity of the absorption layer 14 was amorphous, although slight crystallinity was observed. The layer thickness of the absorption layer 14 was set to 33 nm. Next, a back surface conductive film 15 formed of chromium nitride (CrN) was formed on the surface on the opposite side to the surface on which the reflective layer 12 was formed of the substrate 11. The layer thickness of the back surface conductive film 15 was set to 100 nm.

By the procedure above, the reflective photomask blank 100 of Example 1 was produced.

The film formation (formation of each layer) of each film (reflective layer 12, capping layer 13, and absorption layer 14) on the substrate 11 was performed using a multi-source sputtering apparatus. The layer thickness of each film was controlled by a sputtering time. The absorption layer 14 was formed such that the N/In ratio was 1.0 by controlling the amount of oxygen introduced into a chamber during sputtering by a reactive sputtering method.

Next, a method for producing a reflective photomask 200 is described with reference to FIGS. 5 to 8.

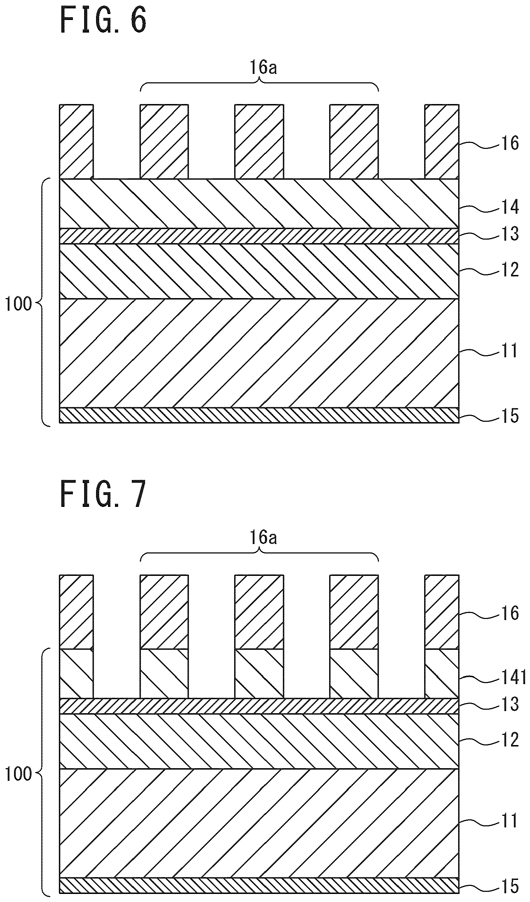

First, a positive chemically amplified resist (SEBP9012: manufactured by Shin-Etsu Chemical Co., Ltd.) was applied by spin coating on the absorption layer 14 of the reflective photomask blank 100 as illustrated in FIG. 5. The layer thickness of the positive chemically amplified resist was set to 120 nm. Then, the applied positive chemically amplified resist was baked at 110°C for 10 minutes to form a resist film 16. Next, a predetermined pattern was drawn on the resist film 16 using an electron beam lithography system (JBX3030: manufactured by JEOL Ltd.). Next, pre-baking treatment was performed at 110°C for 10 minutes, and then development treatment was performed using a spray-development machine (SFG3000: manufactured by SIGMAMELTEC LTD.). Thus, a resist pattern 16a was formed as illustrated in FIG. 6.

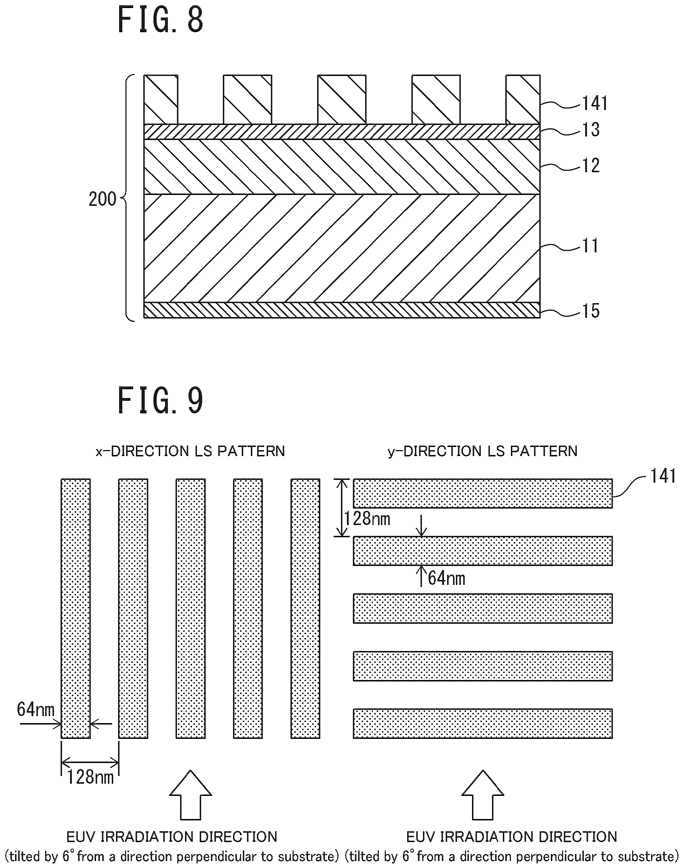

Next, the absorption layer 14 was subjected to patterning of a mask pattern by dry etching mainly containing a chlorine-based gas using the resist pattern 16a as an etching mask. Thus, an absorption pattern (absorption pattern layer) 141 was formed on the absorption layer 14 as illustrated in FIG. 7. Next, the resist pattern 16a was peeled off, thereby producing the reflective photomask 200 of Example 1 as illustrated in FIG. 8.

In this example, the absorption pattern 141 formed on the absorption layer 14 contains an LS (line and space) pattern with a line width of 64 nm, an LS pattern with a line width of 200 nm for measuring the film thickness of an absorption layer using AFM, and a 4 mm square absorption layer removed part for EUV reflectance measurement on the reflective photomask 200 for transfer evaluation. In this example, the LS pattern with a line width of 64 nm was designed in each of the x-direction and the y-direction as illustrated in FIG. 9 such that the influence of the shadowing effect by EUV irradiation was able to be easily viewed.

The layer thickness of the absorption layer 14 was measured by a transmission electron microscope. The same measurement was performed also in Examples 2 to 5 and Comparative Examples 1 to 7 below.

[Example 2]

In Example 2, a layer in which the atomic number ratio (N/In) of indium (In) and nitrogen (N) was 1.0, and the total content of indium (In) and nitrogen (N) was 70 at% of the entire absorption layer 14, and Ga was contained in the proportion of the remaining 30 at% was formed as the absorption layer 14. The layer thickness of the absorption layer 14 was set to 33 nm. The reflective photomask blank 100 and the reflective photomask 200 of Example 2 were produced in the same manner as in Example 1, except for the above.

[Example 3]

In Example 3, a layer in which the atomic number ratio (N/In) of indium (In) and nitrogen (N) was 1.0, and the total content of indium (In) and nitrogen (N) was 70 at% of the entire absorption layer 14, and Ta was contained in the proportion of the remaining 30 at% was formed as the absorption layer 14. The layer thickness of the absorption layer 14 was set to 33 nm. The reflective photomask blank 100 and the reflective photomask 200 of Example 3 were produced in the same manner as in Example 1, except for the above.

[Example 4]

In Example 4, a layer in which the atomic number ratio (N/In) of indium (In) and nitrogen (N) was 0.5, and the total content of indium (In) and nitrogen (N) was 100 at% of the entire absorption layer 14 was formed as the absorption layer 14. The layer thickness of the absorption layer 14 was set to 33 nm. The reflective photomask blank 100 and the reflective photomask 200 of Example 4 were produced in the same manner as in Example 1, except for the above.

[Example 5]

In Example 5, a layer in which the atomic number ratio (N/In) of indium (In) and nitrogen (N) was 1.5, and the total content of indium (In) and nitrogen (N) was 100 at% of the entire absorption layer 14 was formed as the absorption layer 14. The layer thickness of the absorption layer 14 was set to 33 nm. The reflective photomask blank 100 and the reflective photomask 200 of Example 5 were produced in the same manner as in Example 1, except for the above.

[Comparative Example 1]

In Comparative Example 1, a layer in which the atomic number ratio (N/In) of indium (In) and nitrogen (N) was 0, and the content of indium (In) was 100 at% of the entire absorption layer 14 was formed as the absorption layer 14. The layer thickness of the absorption layer 14 was set to 33 nm. The reflective photomask blank 100 and the reflective photomask 200 of Comparative Example 1 were produced in the same manner as in Example 1, except for the above.

[Comparative Example 2]

In Comparative Example 2, a layer in which the atomic number ratio (N/In) of indium (In) and nitrogen (N) was 1.0, and the total content of indium (In) and nitrogen (N) was 100 at% of the entire absorption layer 14 was formed as the absorption layer 14. The layer thickness of the absorption layer 14 was set to 50 nm. The reflective photomask blank 100 and the reflective photomask 200 of Comparative Example 2 were produced in the same manner as in Example 1, except for the above.

[Comparative Example 3]

In Comparative Example 3, a layer in which the atomic number ratio (N/In) of indium (In) and nitrogen (N) was 1.0, and the total content of indium (In) and nitrogen (N) was 30 at% of the entire absorption layer 14, and Te was contained in the proportion of the remaining 70 at% was formed as the absorption layer 14. The layer thickness of the absorption layer 14 was set to 26 nm. The reflective photomask blank 100 and the reflective photomask 200 of Comparative Example 3 were produced in the same manner as in Example 1, except for the above.

[Comparative Example 4]

In Comparative Example 4, a layer in which the atomic number ratio (N/In) of indium (In) and nitrogen (N) was 1.0, and the total content of indium (In) and nitrogen (N) was 45 at% of the entire absorption layer 14, and Te was contained in the proportion of the remaining 55 at% was formed as the absorption layer 14. The layer thickness of the absorption layer 14 was set to 26 nm. The reflective photomask blank 100 and the reflective photomask 200 of Comparative Example 4 were produced in the same manner as in Example 1, except for the above.

[Comparative Example 5]

In Comparative Example 5, a layer in which the atomic number ratio (N/In) of indium (In) and nitrogen (N) was 0.4, and the total content of indium (In) and nitrogen (N) was 100 at% of the entire absorption layer 14 was formed as the absorption layer 14. The layer thickness of the absorption layer 14 was set to 33 nm. The reflective photomask blank 100 and the reflective photomask 200 of Comparative Example 5 were produced in the same manner as in Example 1, except for the above.

[Comparative Example 6]

In Comparative Example 6, a layer in which the atomic number ratio (N/In) of indium (In) and nitrogen (N) was 1.0, and the total content of indium (In) and nitrogen (N) was 100 at% of the entire absorption layer 14 was formed as the absorption layer 14. The layer thickness of the absorption layer 14 was set to 15 nm. The reflective photomask blank 100 and the reflective photomask 200 of Comparative Example 6 were produced in the same manner as in Example 1, except for the above.

[Comparative Example 7]

In Comparative Example 7, a layer in which the atomic number ratio (N/In) of indium (In) and nitrogen (N) was 1.0, and the total content of indium (In) and nitrogen (N) was 100 at% of the entire absorption layer 14 was formed as the absorption layer 14. The layer thickness of the absorption layer 14 was set to 47 nm. The reflective photomask blank 100 and the reflective photomask 200 of Comparative Example 7 were produced in the same manner as in Example 1, except for the above.

[Existing example]

Separately from Examples 1 to 5 and Comparative Examples 1 to 7 described above, a reflective photomask blank having a conventional tantalum (Ta)-based absorption layer and a reflective photomask (hereinafter also referred to as "existing Ta-based mask") were also produced. The reflective photomask blank has a reflective layer in which molybdenum (Mo) layers and silicon (Si) layers were repeatedly (number of repetitions: 40) deposited on a synthetic quartz substrate having a low thermal expansion property, a capping layer 13 containing ruthenium (Ru) and having a layer thickness of 3.5 nm, and the absorption layer 14 in the same manner as in Examples 1 to 5 and Comparative Examples 1 to 7. However, as the absorption layer 14, TaO was formed into a film having a layer thickness of 2 nm on TaN having a layer thickness of 58 nm. For the reflective photomask (existing Ta-based mask), a mask pattern was patterned to the absorption layer 14 of the reflective photomask in the same manner as in Examples 1 to 5 and Comparative Examples 1 to 7.

Hereinafter, evaluation items evaluated in Examples are described.

(Wafer exposure evaluation)

Using an EUV exposure apparatus (NXE3300B: manufactured by ASML), the mask pattern of the reflective mask 200 of each of Examples 1 to 5 and Comparative Examples 1 to 7 was transferred and exposed on a semiconductor wafer coated with an EUV positive chemically amplified resist. The exposure amount was adjusted such that the x-direction LS pattern illustrated in FIG. 9 was transferred as designed. Then, a transferred resist pattern was observed and measured for the line width by an electron beam dimension measuring machine, and how the HV bias value changes in the reflective photomask 200 in each of Examples 1 to 5 and Comparative Examples 1 to 7 was compared by simulation.

The HV bias value is a line width difference of a transfer pattern depending on the direction of the mask pattern, i.e., a difference between the line width in the horizontal (H) direction and the line width in the vertical (V) direction. The line width in the H direction indicates the line width of a linear pattern orthogonal to a plane formed by an incident light and a reflected light (hereinafter sometimes referred to as "incident plane"). The line width in the V direction indicates the line width of a linear pattern parallel to the incident plane. More specifically, the line width in the H direction is the length in the direction parallel to the incident plane, and the line width in the V direction is the length in the direction orthogonal to the incident plane.

(Heat resistance)

Before and after the exposure using the EUV exposure apparatus (NXE3300B: manufactured by ASML), the layer thickness and the reflectance Ra of the absorption pattern layer 141 of the reflective photomask 200 were measured, and it was confirmed whether a film reduction and a change in the reflectance Ra of the absorption pattern layer 141 occurred before and after the EUV exposure. When the film reduction and the change in the reflectance Ra of the absorption pattern layer 141 were not confirmed, "o" is indicated in the column of "Heat resistance". When the film reduction and the change in the reflectance Ra of the absorption pattern layer 141 were confirmed, "×" is indicated in the column of "Heat resistance" because long-term use is difficult.

Table 1 is a table showing the HV bias and the heat resistance of Examples 1 to 5, Comparative Examples 1 to 7, and the existing Ta-based mask.

[Table 1]

|  | Material | N/In | In + N at% (atomic percent) | Layer thickness | HV bias | Heat resistance | Determination |
|---|---|---|---|---|---|---|---|
| Ex. 1 | InN | 1.0 | 100 | 33 nm | 5.13 | ○ | ○ |
| Ex. 2 | InGaN | 10 | 70 | 33 nm | 4.17 | ○ | ○ |
| Ex. 3 | InTaN | 1.0 | 70 | 33 nm | 4.61 | ○ | ○ |
| Ex. 4 | InN | 0.5 | 100 | 33 nm | 5.13 | ○ | ○ |
| Ex. 5 | InN | 1.5 | 100 | 33 nm | 5.13 | ◎ | ○ |
| Comp Ex. 1 | In | - | - | 33 nm | - | × | × |
| Comp Ex. 2 | InN | 1.0 | 100 | 50 nm | - | ○ | × |
| Comp Ex. 3 | InTeN | 1.0 | 30 | 26 nm | 5.01 | × | × |
| Comp Ex. 4 | InTeN | 1.0 | 45 | 26 nm | 5.25 | × | × |
| Comp Ex. 5 | InN | 0.4 | 100 | 33 nm | 5.13 | × | × |
| Comp Ex. 6 | InN | 1.0 | 100 | 15 nm | - | ○ | × |
| Comp Ex. 7 | InN | 1.0 | 100 | 47 nm | - | ○ | × |
| Existing example | Existing Ta-based mask | - | - | 60 nm | 8.65 | ○ | Δ |

Table 1 shows the comparison of the HV bias of each of Examples and Comparative Examples. According to Table 1, as a result of the transfer and exposure to the semiconductor substrate by the EUV light using the existing Ta-based mask, the y-direction pattern dimension was 20 nm and the HV bias value was 8.65 nm. On the other hand, the HV bias of the reflective photomask 200 of Example 1 was 5.13 nm, the HV bias of the reflective photomask 200 of Example 2 was 4.17 nm, the HV bias of the reflective photomask 200 of Example 3 was 4.61 nm, the HV bias of the reflective photomask 200 of Example 4 was 5.13 nm, and the HV bias of the reflective photomask 200 of Example 5 was 5.13 nm. The HV bias of the reflective photomask 200 of Comparative Example 3 was 5.01 nm, the HV bias of the reflective photomask 200 of Comparative Example 4 was 5.25 nm, and the HV bias of the reflective photomask 200 of Comparative Example 5 was 5.13 nm. Therefore, it was able to be confirmed that the shadowing effect can be further suppressed or reduced as compared with the existing Ta-based mask. The transfer pattern of the reflective photomask 200 of Comparative Example 6 had large roughness due to insufficient contrast and the transfer patterns of the reflective photomasks 200 of Comparative Example 1, Comparative Example 2, and Comparative Example 7 were not resolved, and therefore the evaluation of the HV bias thereof was not able to be performed.

Table 1 shows the comparison of the heat resistance of each of Examples and Comparative Examples. In Table 1, when the existing Ta-based mask was used, the film reduction and the change in the reflectance Ra were hardly confirmed. Similarly, also when the reflective photomasks 200 of Examples 1 to 5 and Comparative Example 2, Comparative Example 6, and Comparative Example 7 were used, the film loss and the change in the reflectance Ra were hardly confirmed. Therefore, in Table 1, "o" and "◎" are indicated in the column of "Heat resistance" of each of "Existing example", "Example 1", "Example 2", "Example 3", "Example 4", "Example 5", "Comparative Example 2", "Comparative Example 6", "Comparative Example 7". Therefore, it was able to be confirmed that the reflective photomasks 200 have the heat resistance equal to or higher than that of the existing Ta-based mask. In particular, the reflective photomask 200 of Example 5 was evaluated as "◎" because the film reduction and the change in the reflectance Ra were not able to be confirmed. On the other hand, when the reflective photomasks 200 of Comparative Example 1 and Comparative Examples 3 to 5 were used, the film reduction and the change in the reflectance Ra were confirmed. Therefore, "×" is indicated in the column of "Heat resistance" of each of "Comparative Example 1," "Comparative Example 3," "Comparative Example 4," and "Comparative Example 5".

Table 1 shows the overall evaluation of the HV bias and the heat resistance. In Table 1, when the HV bias value is lower than the HV bias value (8.65) of the existing Ta-based mask and "o" or "◎" is indicated in the column of the heat resistance, "o" is indicated in the column of "Determination". When the HV bias value is larger than the HV bias value (8.65) of the existing mask or when "×" is indicated in the column of the heat resistance, "×" is indicated in the column of "Determination". Therefore, in Table 1, "o" is indicated in the column of "Determination" of each of "Example 1", "Example 2", "Example 3", "Example 4", and "Example 5". On the other hand, "x" is indicated in the column of "Determination" of each of "Comparative Example 1", "Comparative Example 2", "Comparative Example 3", "Comparative Example 4", "Comparative Example 5", "Comparative Example 6", and "Comparative Example 7". In "Existing example", the HV bias value is 8.65, and therefore "Δ" is indicated in the column of "Determination".

Thus, a result was obtained that, when the reflective photomask 200 is such that the absorption pattern layer 141 contains a total of 50 at% or more of indium (In) and nitrogen (N), the atomic number ratio (N/In) of nitrogen (N) to indium (In) in the absorption pattern layer 141 is 0.5 or more and 1.5 or less, and the layer thickness of the absorption pattern layer 141 is 17 nm or more and 45 nm or less, both the optical density OD value and the heat resistance are good, the shadowing effect can be reduced, the life is long, and the transfer performance is high. More specifically, it was able to be confirmed that the reflective photomask 200 having more excellent transfer performance is obtained. In other words, it can be confirmed that the use of the reflective photomask blank 100 according to the embodiment enables the production of the reflective photomask 200 capable of suppressing or reducing the shadowing effect of the reflective photomask for patterning transfer using the light having a wavelength in the extreme ultraviolet region as a light source and having sufficient heat resistance in exposure.

Industrial Applicability

The reflective photomask blank and the reflective photomask according to the present invention can be suitably used for forming a fine pattern by EUV exposure in a manufacturing process of a semiconductor integrated circuit and the like.

Reference Signs List

1 substrate
2 reflective layer
3 capping layer
4 absorption layer
41 absorption pattern (absorption pattern layer)
10 reflective photomask blank
20 reflective photomask
11 substrate
12 reflective layer
13 capping layer
14 absorption layer
141 absorption pattern (absorption pattern layer)
15 back surface conductive film
16 resist film
16a resist pattern
100 reflective photomask blank

200    reflective photomask

**Claims**

1.  A reflective photomask blank for producing a reflective photomask for pattern transfer using an extreme ultraviolet light as a light source comprising:

    a substrate;
    a reflective layer including a multi-layer film formed on the substrate; and
    an absorption layer formed on the reflective layer, wherein
    the absorption layer contains a total of 50 at% or more of indium (In) and nitrogen (N),
    an atomic number ratio (N/In) of nitrogen (N) to indium (In) in the absorption layer is 0.5 or more and 1.5 or less, and
    a layer thickness of the absorption layer is 17 nm or more and 45 nm or less.

2.  The reflective photomask blank according to claim 1, wherein the absorption layer further contains one or more elements selected from the group consisting of tantalum (Ta), platinum (Pt), tellurium (Te), zirconium (Zr), hafnium (Hf), titanium (Ti), tungsten (W), silicon (Si), chromium (Cr), gallium (Ga), molybdenum (Mo), tin (Sn), palladium (Pd), nickel (Ni), boron (B), fluorine (F), oxygen (O), carbon (C), and hydrogen (H).

3.  The reflective photomask blank according to claim 1 or 2, comprising:
    a capping layer between the reflective layer and the absorption layer.

4.  A reflective photomask for pattern transfer using an extreme ultraviolet light as a light source comprising:

    a substrate;
    a reflective layer including a multi-layer film formed on the substrate; and
    an absorption pattern layer formed on the reflective layer, wherein
    the absorption pattern layer contains a total of 50 at% or more of indium (In) and nitrogen (N),
    an atomic number ratio (N/In) of nitrogen (N) to indium (In) in the absorption layer is 0.5 or more and 1.5 or less, and
    a layer thickness of the absorption pattern layer is 17 nm or more and 45 nm or less.

5.  The reflective photomask according to claim 4, wherein the absorption pattern layer further contains one or more elements selected from the group consisting of tantalum (Ta), platinum (Pt), tellurium (Te), zirconium (Zr), hafnium (Hf), titanium (Ti), tungsten (W), silicon (Si), chromium (Cr), gallium (Ga), molybdenum (Mo), tin (Sn), palladium (Pd), nickel (Ni), boron (B), fluorine (F), oxygen (O), carbon (C), and hydrogen (H).

# FIG. 1

# FIG. 2

FIG. 3

FIG. 4

FIG. 5

## FIG. 6

## FIG. 7

# FIG. 8

# FIG. 9

x-DIRECTION LS PATTERN          y-DIRECTION LS PATTERN

EUV IRRADIATION DIRECTION          EUV IRRADIATION DIRECTION
(tilted by 6° from a direction perpendicular to substrate) (tilted by 6° from a direction perpendicular to substrate)

## INTERNATIONAL SEARCH REPORT

| | International application No. |
|---|---|
| | **PCT/JP2021/041787** |

**A. CLASSIFICATION OF SUBJECT MATTER**

*G03F 1/24*(2012.01)i; *C23C 14/06*(2006.01)i
FI: G03F1/24; C23C14/06 R

According to International Patent Classification (IPC) or to both national classification and IPC

**B. FIELDS SEARCHED**

Minimum documentation searched (classification system followed by classification symbols)

G03F1/24; C23C14/06

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2006-190900 A (TOPPAN PRINTING CO LTD) 20 July 2006 (2006-07-20)<br>paragraphs [0052]-[0056] | 1-5 |
| A | WO 2017/038213 A1 (HOYA CORP) 09 March 2017 (2017-03-09)<br>paragraphs [0071]-[0074] | 1-5 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **29 November 2021** | **14 December 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
**Information on patent family members**

International application No.

**PCT/JP2021/041787**

| Patent document cited in search report | | | Publication date (day/month/year) | Patent family member(s) | Publication date (day/month/year) |
|---|---|---|---|---|---|
| JP | 2006-190900 | A | 20 July 2006 | (Family: none) | |
| WO | 2017/038213 | A1 | 09 March 2017 | US 2020/0064726 A1 paragraphs [0091]-[0094] KR 10-2018-0048573 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011176162 A